# EUROPÄISCHE PATENTANMELDUNG

(11) **EP 1 650 800 A2**
(43) Veröffentlichungstag der Anmeldung: **26.04.2006**
(21) Anmeldenummer: 05017590.0
(22) Anmeldetag: 12.08.2005
(51) Int. Cl.: H01L 23/48, H01L 21/60, H01L 25/07

(54) **Leistungshalbleitermodul mit Druckkontakteinrichtung**

(30) Priorität: 20.10.2004 DE 102004051039
(71) Anmelder: Semikron Elektronik GmbH & Co. KG Patentabteilung, 90431 Nürnberg (DE)
(72) Erfinder: Augustin, Karlheinz, 90768 Fürth (DE); Steger, Jürgen, 91355 Hilpoltstein (DE)

(57) **Zusammenfassung**

Die Erfindung beschreibt ein Leistungshalbleitermodul mit Druckkontakteinrichtung. Dieses weist mindestens ein Substrat, ein rahmenartiges Gehäuse und ein Gehäuseteil zur Druckeinleitung auf. Hierbei besteht das Substrat aus einem Isolierstoffkörper mit einer dem Leistungshalbleitermodulinneren zugewandten metallische Schicht, die vorzugsweise in sich strukturierten ist und dadurch voneinander isolierte Leiterbahnen bildet. Auf diesen Leiterbahnen sind Leistungshalbleiterbauelemente angeordnet und schaltungsgerecht verbunden. Die schaltungsgerechten Verbindungen sind als Bandbondverbindungen ausgestaltet. Als Druck übertragende Elemente sind Stempel vorgesehen, die sich auf Bondfüßen der Bandbondverbindungen abstützen, wobei der Gehäuseteil zur Druckeinleitung diese Stempel mit Druck beaufschlagt.

## Beschreibung

Die Erfindung beschreibt ein kompaktes Leistungshalbleitermodul mit Druckkontakteinrichtung. Derartige Leistungshalbleitermodule finden Anwendung in Schaltungsanordnungen bei denen eine besondere Zuverlässigkeit gefordert ist, die kennzeichnend ist für Druckkontaktaufbauten.

Der Stand der Technik druckkontaktierter Leistungshalbleitermodule ist äußerst vielfältig. Es gibt als Basis der vorliegenden Erfindung zwei wesentliche Ausgestaltungen von druckkontaktierten Leistungshalbleitermodulen, beispielhaft bekannt aus der DE 199 03 875 A1 bzw. aus der DE 102 13 648 A1. Die DE 199 03 875 A1 offenbart Druckkontaktaufbauten, die eine den Druck einleitende Druckplatte und ein den Druck auf ein Substrat übertragendes Druckelement aufweisen. Vorzugsweise ist hierbei zwischen der Druckplatte und dem Druckelement ein flexibler Druckspeicher angeordnet.

Weiterhin ist aus der DE 102 13 648 A1 ein druckkontaktiertes Leistungshalbleitermodul bekannt, wobei dessen Deckel einerseits der Druckeinleitung sowie auch der Druckausübung auf ein Substrat dient.

Beide Ausgestaltungen weisen jeweils ein rahmenartiges isolierendes Kunststoffgehäuse sowie mindestens ein isolierendes Substrat auf. Auf diesem Substrat ist mindestens eine Leiterbahn und hierauf mindestens ein Leistungshalbleiterbauelement angeordnet. Dieses Leistungshalbleiterbauelement ist mit Anschlusselementen, weiteren Leiterbahnen und / oder weiteren Leistungshalbleiterbauelementen schaltungsgerecht verbunden. Den Stand der Technik derartiger modulintemer Verbindungen bilden Drahtbondverbindungen.

Nachteilig an dem genannten Stand der Technik ist, dass die Druckeinleitung jeweils auf das Substrat ausgeübt wird und hierfür Fläche des Substrats beansprucht wird, die somit keine Bauelemente und auch keine Verbindungselemente, wie Bondverbindungen oder externe Anschlüsse tragen kann. All diesen Ausgestaltungen ist gemein, dass der beste thermische Kontakt mit einem Kühlkörper an denjenigen Stellen des Substrats entsteht an denen Kontaktstempel des Druckelements das Substrat auf den Kühlkörper drücken. Dies ist dahingehend nachteilig, dass die meiste Wärme in den Leistungshalbleiterbauelementen entsteht und daher direkt unter diesen auch der beste Wärmeabtransport stattfinden sollte, was beim genannten Stand der Technik nicht möglich ist.

Die DE 102 13 648 A1 offenbart weiterhin die Druckausübung auf ein gehaustes Leistungshalbleiterbauelement innerhalb eines Leistungshalbleitermoduls. Demgegenüber offenbart die DE 101 21 970 A1 die Druckausübung auf ein ungehaustes Leistungshalbleiterbauelement mittels eine flexiblen Leiterplatte. Diese Leiterplatte dient zusätzlich auch der elektrischen Verbindungen des Leistungshalbleiterbauelements.

Allerdings zeigt keine der genannten, den Stand der Technik repräsentierenden, Druckschriften eine Druckeinleitung auf ein gebondetes Leistungshalbleiterbauelement.

Aus der DE 195 29 237 C1 ist allerdings eine Druckeinleitung direkt auf ein Leistungshalbleiterbauelement bekannt. Hierbei ist das Halbleiterbauelement mittels Drahtbondverbindungen mit Leiterbahnen auf einem Substrat verbunden. Der Druck wird auf das Leistungshalbleiterbauelement mittels eines Druckkissens auf die Oberfläche des Leistungshalbleiterbauelements eingeleitet. Hierbei werden auch die Drahtbondverbindungen mit Druck beaufschlagt. Bisherige Versuche haben allerdings gezeigt, dass eine Druckeinleitung nach der Lehre dieser Druckschrift häufig zur Abscherung der Drahtbondverbindungen führt.

Der vorliegenden Erfindung liegt die Aufgabe zu Grunde ein druckkontaktiertes Leistungshalbleitermodul vorzustellen, das einen hochwirksame Wärmeabtransport von den Leistungshalbleiterbauelementen bei gleichzeitig kompakter Bauform aufweist.

Diese Aufgabe wird gelöst durch eine Anordnung nach dem Anspruch 1, spezielle Ausgestaltungen finden sich in den Unteransprüchen.

Der Grundgedanke der Erfindung geht aus von einem Leistungshalbleitermodul zur druckkontaktierten Montage auf einem Kühlkörper wobei das Leistungshalbleitermodul ein rahmenartiges isolierendes Kunststoffgehäuse aufweist. Dieses Kunststoffgehäuse weist weiterhin einen vorzugsweise einstückig mit dem Gehäuse verbundenen Deckel auf. Die zweite Deckfläche wird gebildet durch ein Substrat, das aus einer Isolationsschicht und mindestens einer hierauf angeordneten metallischen Schicht besteht, die dem Leistungshalbleitermodulinneren zugewandte ist. Diese metallische Schicht ist vorteilhafterweise in sich strukturiert und bildet somit Leiterbahnen des Leistungshalbleitermoduls. Auf dieser Leiterbahnen ist mindestens ein Leistungshalbleiterbauelement angeordnet und mit mindestens einem nach außen führenden Anschlusselement, einer weiteren Leiterbahn und / oder einem weiteren Leistungshalbleiterbauelement schaltungsgerecht verbunden.

Diese schaltungsgerechten Verbindungen sind zumindest teilweise als Bandbondverbindung ausgestaltet. Bandbondverbindungen in erfindungsgemäßen Leistungshalbleitermodulen weisen gegenüber Drahtbondverbindungen zwei wesentliche Vorteile auf. Einerseits eine deutlich höhere Stromtragfähigkeit einer einzelnen Verbindung und andererseits einen in seinen lateralen Ausdehnungen deutlich größeren Bondfuß. Der Bondfuß ist derjenige Teil der Bondverbindung, welcher Kontakt mit dem Leistungshalbleiterbauelement oder der Leiterbahn des Substrats hat. Als Druck übertragendes Elemente sind daher Stempel vorgesehen sind, die sich auf den Bondfüßen der Bandbondverbindungen abstützen und durch einen Gehäuseteil zur Druckeinleitung mit Druck beaufschlagt werden.

Die Erfindung wird anhand von Ausführungsbeispielen in Verbindung mit den Fig. 1 bis 4 näher erläutert.

Fig. 1 zeigt einen Schnitt durch ein Leistungshalbleitermodul nach dem Stand der Technik.

Fig. 2 und 3 zeigen verschiedene Ausgestaltung eines Leistungshalbleitermoduls mit erfindungsgemäßer Druckkontakteinrichtung.

Fig. 4 zeigt einen Teil der erfindungsgemäßen Druckkontakteinrichtung am Beispiel der Druckeinleitung auf eine Leistungsdiode.

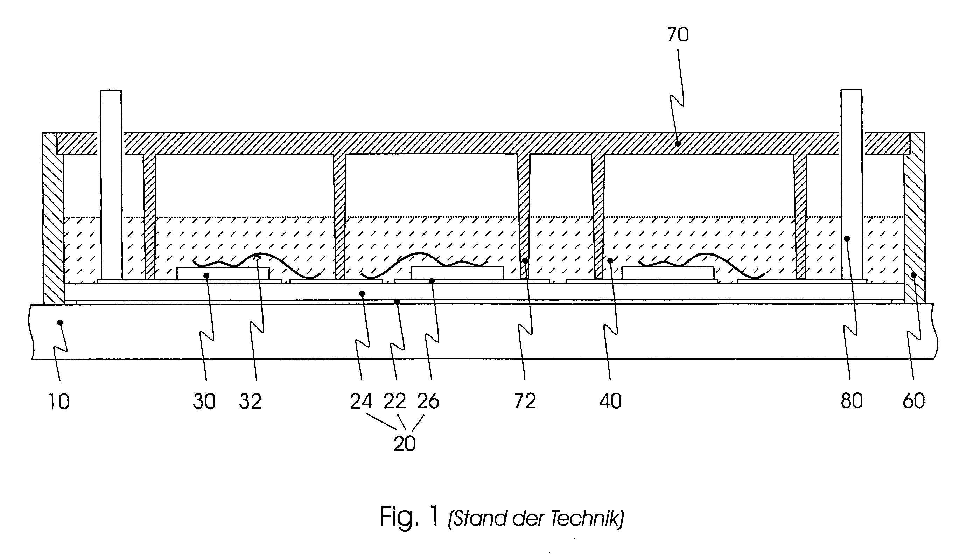

Fig. 1 zeigt einen Schnitt durch ein Leistungshalbleitermodul nach dem Stand der Technik. Dargestellt ist ein Kühlkörper (10), zur Abfuhr im Leistungshalbleitermodul entstandener Wärme mit einem auf diesem Kühlkörper angeordneten Substrat (20) sowie ein dieses umrahmendes und überdeckendes Gehäuse (60) mit Deckel (70).

Das Substrat (20) besteht aus einem Isolierstoffkörper (24), vorzugsweise einer Industriekeramik wie Aluminiumoxid oder Aluminiumnitrit, sowie auf beiden Seiten dieses Isolierstoffkörpers metallischen Schichten (22, 26). Die metallischen Schichten sind hierbei mittels des bekannten DCB- Verfahrens auf dem Isolierstoffkörper (24) aufgebracht. Vorzugsweise ist die dem Inneren des Gehäuses (60) zugewandete metallische Schichten (22) in sich strukturiert und bildet somit voneinander isolierte Leiterbahnen. Diese Leiterbahnen tragen Leistungshalbleiterbauelemente (30), wie Dioden, Thyristoren, IGBTs und / oder MOS-FETs, die hierauf mittels Lötverbindungen angeordnet sind. Weitere schaltungsgerechte Verbindungen der Leistungshalbleiterbauelemente (30) beispielhaft mit weiteren Leiterbahnen (26) erfolgen mittels Drahtbondverbindungen (32).

Weiterhin sind innerhalb des Gehäuses Verbindungselemente (80) angeordnet. Diese Verbindungselemente dienen der elektrischen Verbindung der Leiterbahnen (26) des Substrats (20) mit den externen Zuleitungen und durchdringen daher das Gehäuse (60) bzw. den Deckel (70) an geeigneter Stelle.

Der Wärmeübergang zwischen dem Substrat (20) und dem Kühlkörper (10) ist für Leistungshalbleitermodule eine entscheidende Größe, die direkt deren Leistungsfähigkeit bestimmt. Die in den Leistungshalbleiterbauelementen (30) während des Betriebs entstehende Wärme muss daher möglichst effizient abgeführt werden. Hierzu weist das Leistungshalbleitermodul eine Druckkontakteinrichtung auf. Diese wird gebildet durch den Deckel (70) und hiermit einstückig verbundenen Stempeln (72). Diese Stempel (72) ragen vom Deckel (90) ins Innere des Leistungshalbleitermoduls bis auf das Substrat (20) und hierbei auf Teile der Leiterbahnen. Durch eine geeignete Befestigung des Leistungshalbleitermoduls auf dem Kühlkörper (10) wird über das Gehäuse (60), vorzugsweise über den Deckel (70) Druck eingeleitet, der sich über die Stempel (72) fortsetzt und somit das Substrat (20) auf den Kühlkörper (10) drückt.

Nachteilig ist hierbei, dass für diese Druckeinleitung auf dem Substrat Flächen vorgehalten werden müssen, die der Druckeinleitung dienen und somit nicht zur Anordnung von Leistungshalbleiterbauelementen oder Verbindungselementen zur Verfügung stehen.

Die innere Isolierung des Leistungshalbleitermoduls wird nach dem Stand der Technik gebildet durch einen Silikonkautschuk (40), der das Innere des Leistungshalbleitermoduls bis auf circa halbe Höhe ausfüllt.

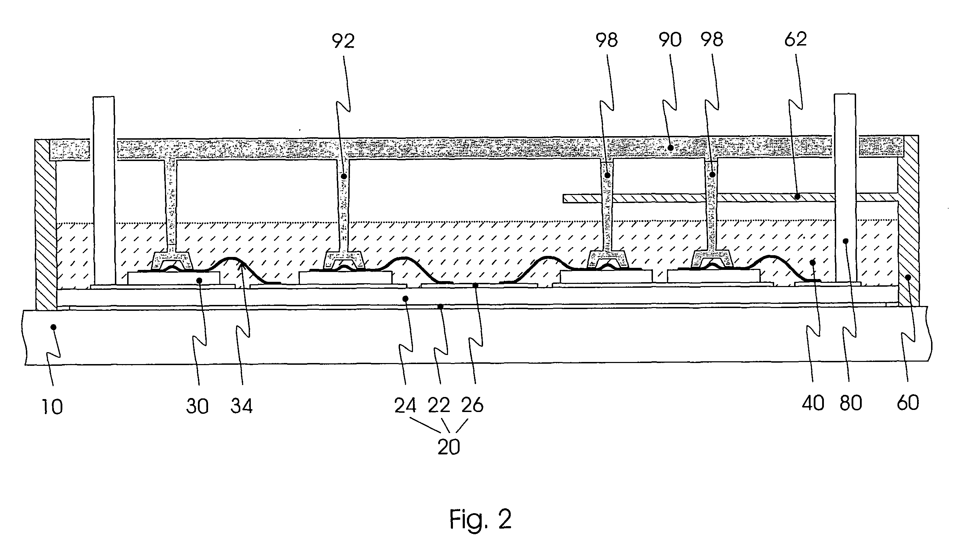

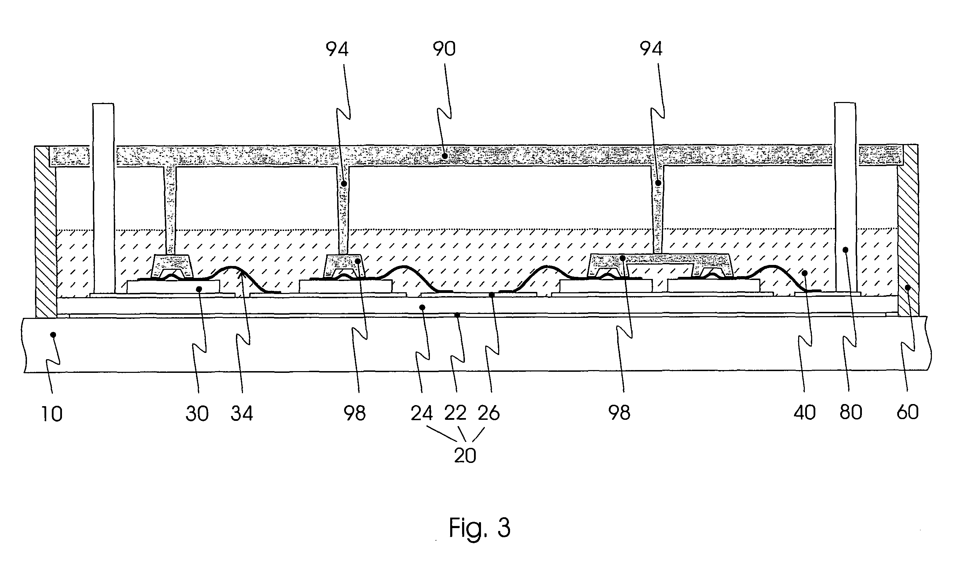

Fig. 2 und 3 zeigen jeweils ein Leistungshalbleitermodul mit verschiedenen erfindungsgemäß ausgebildeten Druckkontakteinrichtungen, angeordnet auf jeweils einem Kühlkörper (10). Das jeweilige Leistungshalbleitermodul selbst weist wie unter Fig. 1 beschrieben ein Substrat (20) sowie ein dieses umrahmendes Gehäuse (60) und einen Deckel (90) auf. Hierbei sind alle identischen Komponenten mit gleichen Bezugszeichen versehen. Das Gehäuse (60) und der Deckel (90) können einstückig oder hier vorzugsweise zweistückig ausgebildet sein.

Erfindungsgemäß weist das Leistungshalbleitermodul zur elektrischen Verbindung der Leistungshalbleiterbauelemente (30) mit den Leiterbahnen (26) Bandbondverbindungen (34) auf. Diese weisen gegenüber Drahtbondverbindungen (vgl. Fig. 2, 32) den wesentlichen Unterschied auf, dass die Bondfüße, also die Verbindungsflächen zwischen dem Leistungshalbleiterbauelement (30) bzw. der Leiterbahn (26) und dem Bondmaterial wesentlich größer sind. Dieser Größenunterschied liegt bei einem Faktor zwischen 4 und 20 zwischen Band- und Drahtbondverbindungen.

Die erfindungsgemäße Druckkontakteinrichtung weist Stempel (92, 94, 98) auf, die den Druck auf die Bondfüße der Bandbondverbindungen (34) einleiten. Dargestellt ist hier eine Einleitung des Drucks auf diejenigen Bondfüße, die das Leistungshalbleiterbauelement (30) kontaktieren. Dies ist bevorzug, weil somit derjenige Abschnitt des Substrats (20) maximale Druckeinleitung erfährt, auf dem die Leistungshalbleiterbauelemente (30) und damit die Wärmeerzeuger angeordnet sind. Technologisch einfacher ist eine Druckeinleitung auf diejenigen Bondfüße, die auf einer Leiterbahn (26) angeordnet sind. Beide Varianten oder auch eine Mischform dieser Varianten weist den Vorteil auf, dass somit Flächen mehrfach genutzt werden, entweder als Fläche für das Leistungshalbleiterbauelement (30) oder für dessen Verbindung zur Leiterbahn (26) und gleichzeitig zur Druckkontaktierung.

Zur Druckeinleitung vom Gehäuse (60) auf das Substrat weist der Deckel (70) eine Mehrzahl von Stempeln (92) auf, deren jeweiliger druck einleitender Teil derart ausgebildet ist, dass er auf mindestens einen, vorzugsweise eine Mehrzahl von Bondfüßen drückt. Dargestellt ist die Druckeinleitung auf eine Mehrzahl von auf einem Leistungshalbleiterbauelement (30) angeordneten Bondfüßen. Hierbei sind der Deckel (90), die Stempel (92) und die jeweiligen Druck übertragenden Teile der Stempel einstückig ausgebildet.

Eine mehrteilige Ausgestaltung der jeweiligen Stempel (94), speziell eine zweitteilige, ist dann bevorzug, wenn mit einem Stempel (94) auf mehrere Leistungshalbleiterbauelemente (30) gedrückt werden soll. Hierbei überragt der Druck übertragenden Teil (96) des Stempels (94) mehrere Leistungshalbleiterbauelement (30) und der mit dem Deckel (90) verbunden Teil des Stempels (94) drück zentral auf den Druck übertragenden Teil (96). Hierbei ist es vorteilhaft, wenn der jeweilige Druck übertragende Teil (96) des Stempels (94) mittels einer Klebeverbindung auf den zugeordneten Leistungshalbleiterbauelementen (30) angeordnet ist.

Es ist weiterhin vorteilhaft, wenn im Inneren des Gehäuses (60) ein Hilfsrahmen (62) angeordnet ist, der die Stempel (98) in ihrer Position führt. Hierbei ist eine mehrstückige Ausgestaltung von Deckel (90) und Stempel (98) bevorzugt.

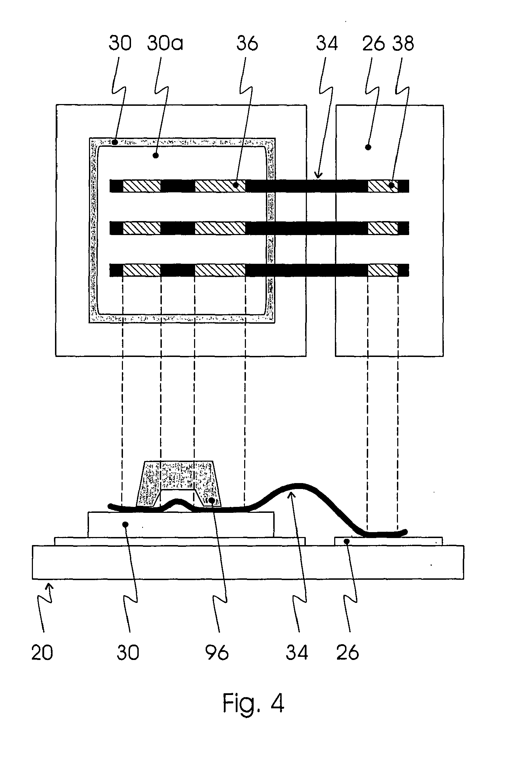

Fig. 4 zeigt einen Teil der erfindungsgemäßen Druckkontakteinrichtung am Beispiel der Druckeinleitung auf eine Leistungsdiode. Dargestellt ist sowohl eine Draufsicht wie auch eine Schnittansicht gemäß Fig. 2. Das Leistungshalbleiterbauelement, hier eine Leistungsdiode, weist eine metallische Oberfläche (30a) auf. Ausgehend von diese Oberfläche (30a) sind 3 Bandbondverbindungen (34) zu einer Leiterbahn (26) des Substrats (20) angeordnet.

Die Bandbondverbindungen (34) weisen Kontaktflächen (36) mit der Oberfläche (30a) des Leistungshalbleiterbauelements (30) sowie Kontaktflächen (38) mit der Leiterbahn (26) auf. Der Druck übertragende Teil des Stempels (96) stütz sich auf die Bandbondverbindungen (34) derart, dass diese Druckfläche kleiner ist als die Kontaktfläche (36) und dass die Druckfläche vollständig innerhalb der lotrechten Projektion der Kontaktfläche (36) auf die Oberseite der Bandbondverbindungen liegt. Hiermit ist gewährleistet, dass die Druckeinleitung nicht direkt über denjenigen Bereichen der Bandbondverbindungen (34) liegt an denen der Kontakt zur Oberfläche (30a) des Leistungshalbleiterbauelements (30) endet. Somit wird ein Abscheren der Bandbondverbindung wirksam verhindert.

## Patentansprüche

1. Leistungshalbleitermodul mit Druckkontakteinrichtung mit mindestens einem Substrat (20), einem rahmenartigen Gehäuse (60) und einem Gehäuseteil (90) zur Druckeinleitung, wobei das Substrat (20) aus einem Isolierstoffkörper (24) mit einer vorzugsweise in sich strukturierten und dadurch voneinander isolierter Leiterbahnen bildenden dem Leistungshalbleitermodulinneren zugewandten metallische Schicht (26) besteht, auf diesen Leiterbahnen sind Leistungshalbleiterbauelement (30) angeordnet und schaltungsgerecht verbunden,
wobei die schaltungsgerechten Verbindungen zumindest teilweise als Bandbondverbindungen (34) ausgestaltet sind und
wobei als Druck übertragende Elemente Stempel (92, 94, 98) vorgesehen sind, die sich auf Bondfüßen der Bandbondverbindungen (34) abstützen und wobei der Gehäuseteil (90) zur Druckeinleitung diese Stempel (92, 94, 98) mit Druck beaufschlagt.

2. Leistungshalbleitermodul nach Anspruch 1,
wobei der Stempel (94) und eine Druck übertragender Teil (96) des Stempels (94) mehrstückig ausgestaltet sind.

3. Leistungshalbleitermodul nach Anspruch 2,
wobei der Druck übertragende Teil des Stempels (98) mittels einer Klebeverbindung auf den Leistungshalbleiterbauelementen (30) fixiert ist.

4. Leistungshalbleitermodul nach Anspruch 1,
wobei die Stempel (98) mittels eines in Inneren des Gehäuses (60) angeordneten Hilfsrahmens (62) fixiert sind.

5. Leistungshalbleitermodul nach Anspruch 1,
wobei sich die jeweiligen Stempel (92, 94, 98) auf einen oder mehrere Bondfüße einer oder mehrerer Bandbondverbindungen (34) abstützen.
